# EUROPÄISCHE PATENTSCHRIFT

(11) **EP 1 393 605 B1**
(45) Veröffentlichungstag und Bekanntmachung des Hinweises auf die Patenterteilung: **24.01.2007**
(21) Anmeldenummer: 02745301.8
(22) Anmeldetag: 18.05.2002
(51) Int. Cl.: H05K 3/36

(54) **LEITERPLATTE MIT MINDESTENS EINEM ELEKTRONISCHEN BAUTEIL**
CIRCUIT BOARD WITH AT LEAST ONE ELECTRONIC COMPONENT
CARTE DE CIRCUITS IMPRIMES POURVUE D'AU MOINS UN COMPOSANT ELECTRONIQUE

(30) Priorität: 01.06.2001 DE 10126655
(43) Veröffentlichungstag der Anmeldung: 03.03.2004
(73) Patentinhaber: ENDRESS + HAUSER GMBH + CO., 79689 Maulburg (DE); Birgel, Dietmar, 79650 Schopfheim (DE)
(72) Erfinder: LOPATIN, Sergej, 79540 Lörrach (DE)
(74) Vertreter: Andres, Angelika Maria
(86) Internationale Anmeldenummer: PCT/EP2002/005512
(87) Internationale Veröffentlichungsnummer: WO 2002/100140

(56) Entgegenhaltungen:
- EP-A- 0 117 809
- EP-A- 0 405 828
- EP-A- 0 702 404
- GB-A- 2 175 149
- US-A- 6 020 559
- US-B1- 6 220 093
- "SMT FAR-BLIND VIA-TO-PAD-CONNECTION" IBM TECHNICAL DISCLOSURE BULLETIN, IBM CORP. NEW YORK, US, Bd. 35, Nr. 7, 1. Dezember 1992 (1992-12-01), Seiten 266-267, XP000333009 ISSN: 0018-8689
- PATENT ABSTRACTS OF JAPAN vol. 1998, no. 10, 31. August 1998 (1998-08-31) & JP 10 135596 A (IWAKI ELECTRON CORP LTD), 22. Mai 1998 (1998-05-22)
- PATENT ABSTRACTS OF JAPAN vol. 015, no. 022 (E-1024), 18. Januar 1991 (1991-01-18) & JP 02 268488 A (TOSHIBA CORP), 2. November 1990 (1990-11-02)

## Beschreibung

Die Erfindung betrifft eine Leiterplatte mit mindestens einem elektronischen Bauteil und ein Verfahren zur Herstellung einer Verbindung zwischen der Leiterplatte und dem Bauteil. Die Verbindung bewirkt sowohl die mechanische Befestigung des Bauteils auf der Leiterplatte als auch den elektrischen Anschluß des Bauteils auf der Leiterplatte.

Elektronische Geräte, insb. Meßgeräte weisen in der Regel mindestens eine Leiterplatte auf, auf der elektronische Bauteile angeordnet sind. Diese Bauteile müssen mechanisch auf der Leiterplatte befestigt werden und elektrisch an in oder auf der Leiterplatte verlaufenden Leiterbahnen angeschlossen werden.

Insb. bei Meßgeräten, die zum Teil sehr hohen mechanischen Belastungen, z.B. ständigen Vibrationen von an einem Meßort arbeitenden Maschinen ausgesetzt sind, ist es dabei besonders wichtig, daß die elektrische und mechanische Verbindung zwischen den Bauteilen und der Leiterplatte hoch belastbar ist.

Heute werden immer häufiger flexible Leiterlatten verwendet, die z.B. platzsparend zusammengerollt in ein elektrisches Gerät, insb. Meßgerät, eingebaut werden.
Bereits bei starren Leiterplatten ist es sehr wichtig, eine mechanisch belastbare Verbindung zwischen der Leiterplatte und den darauf anzubringen Bauteilen zu gewährleisten. Dies gilt natürlich um so mehr bei flexiblen Leiterplatten. Bei diesen sind die Verbindungen zusätzlich durch die Beweglichkeit der Leiterplatte besonders belastet. Es muß auch beim und nach dem Aufrollen der Leiterplatte eine sichere mechanische und elektrische hoch belastbare Verbindung bestehen.

In der EP-A 1069810 ist eine Leiterplatte auf der mindestens ein elektronisches Bauteil angeordnet ist beschrieben, welches Bauteil mindestens zwei elektrische Kontakte aufweist von denen ein erster mit einem ersten Anschluß auf der Leiterplatte durch eine Klebung mit einem leitfähigen Kleber und ein zweiter mit einem zweiten Anschluß auf der Leiterplatte durch eine Lötung verbunden ist.

Lot und Kleber werden auf plane voneinander beabstandete Kontaktflächen auf einer Oberfläche der Leiterplatte aufgebracht. Anschließend wird das Bauteil mit dessen Kontaktflächen derart auf die Oberfläche aufgesetzt, daß die Kontaktflächen des Bauteils die Kontaktflächen der Leiterplatte überdecken. Hierdurch besteht eine sehr rationell herstellbare Verbindung. Insb. derartige Lotverbindungen sind jedoch empfindlich gegenüber Schälbelastungen.

Es ist eine Aufgabe der Erfindung, eine Leiterplatte mit mindestens einem elektrischen Bauteil anzugeben, bei der zwischen der Leiterplatte und dem Bauteil eine mechanisch hoch belastbare elektrische und mechanische Verbindung besteht.

Hierzu besteht die Erfindung in einer Leiterplatte mit
- mindestens einer innen liegenden Leiterbahn,
- einer ersten auf einer ersten Oberfläche der Leiterplatte angeordneten Isolationsschicht,
- einer zweiten auf einer zweiten Oberfläche der Leiterplatte angeordneten Isolationsschicht,
- einer ersten Kontaktstelle an der die Leiterbahn zugänglich ist,
- einer zweiten Kontaktstelle, an der die Leiterbahn durch eine die Leiterplatte vollständig durchdringende Bohrung zugänglich ist, und
- einem auf der ersten Oberfläche angeordneten elektronischen Bauteil,
   -- das eine erste Kontaktfläche aufweist, die mit der ersten Kontaktstelle durch eine Lötung oder eine Klebung mit einem elektrisch leitfähigen Kleber verbunden ist, und
   -- das eine zweite Kontaktfläche aufweist, die mit der zweiten Kontaktstelle durch eine Lötung oder eine Klebung verbunden ist.

Eine besondere Ausführungsform der Leiterplatte nach der Erfindung weist
- zwei von einander beabstandeten zueinander parallelen innen liegenden Leiterbahnen (27) auf,
   -- wovon jene, die der ersten Oberfläche zugewandt ist, an der ersten Kontaktstelle (9) zugänglich ist, und
- wobei beide Leiterbahnen (27) durch die Bohrung (15) zugänglich sind.

Gemäß einer Weiterbildung weist die Bohrung im Bereich der beiden Leiterplatten eine Metallisierung aufweist.

Gemäß einer ersten Ausgestaltung ist die Leiterbahn an der ersten Kontaktstelle durch eine Ausnehmung in der ersten Isolationsschicht zugänglich.

Gemäß einer zweiten Ausgestaltung ist die Leiterbahn an der ersten Kontaktstelle durch eine die Leiterplatte vollständig durchdringende Bohrung zugänglich.

Gemäß einer Ausgestaltung ist das Bauteil ein piezoelektrisches Element, das mindestens eine flächig aufgebrachte Elektrode aufweist, und die Kontaktflächen sind Teilflächen der Elektrode.

Gemäß einer Ausgestaltung der letztgenannten Ausgestaltung bilden die erste und die zweite Kontaktfläche elektrisch eine Einheit.

Ein Vorteil der Erfindung besteht darin, daß ein auf die mechanische Verbindung zwischen Bauteil und Leiterplatte einwirkende Schälbelastung in der Bohrung zumindest teilweise in eine auf das Verbindungsmaterial einwirkende Zugbelastung umgewandelt wird. Herkömmliche Verbindungsmaterialien, insb. Lote, sind gegenüber Zugbelastungen sehr viel beständiger, so daß durch das Vorhandensein mindestens einer solchen Verbindung eine mechanisch sehr belastbare Verbindung besteht.

Auch bietet die Bohrung eine Kontrollmöglichkeit. Es kann von der dem Bauteil abgewandten Seite durch eine einfache Sichtkontrolle geprüft werden, ob Verbindungsmaterial, also Lot oder Kleber, in ausreichender Menge an der richtigen Stelle vorhanden ist.

Die Redundanz, die durch die erste und die zweite Kontaktstelle gegeben ist, bietet zusätzlich eine erhöhte Sicherheit.

Ein weiterer Vorteil der erfindungsgemäßen Verbindungstechnik besteht darin, daß sie maschinell herstellbar ist. Genau wie bei der Bestückung einer Leiterplatte mit SMD-Bauteilen wird auch hier das Verbindungsmaterial, d.h. Lot und/oder Kleber, maschinell, z.B. in Siebdruckverfahren oder mit einem Dispenser aufgebracht. Anschließend erfolgt eine maschinelle Bestückung der Leiterplatte. Der eigentliche Lötvorgang und das Aushärten des Klebers können in einem Arbeitsgang in einem Ofen erfolgen. Die simultane Herstellung von Lot- und Klebverbindungen ist in der am 10.7.1999 eingereichten Europäischen Patentanmeldung EP-A 1 069 810 der Anmelderin beschrieben.

Die Erfindung und weitere Vorteile werden nun anhand der Figuren der Zeichnung, in denen drei Ausführungsbeispiele dargestellt sind, näher erläutert; gleiche Elemente sind in den Figuren mit gleichen Bezugszeichen versehen.
Fig. 1 zeigt schematisch eine Leiterplatte mit einer innen liegenden Leiterbahn und einem darauf angeordneten Bauteil;
Fig. 2 zeigt schematisch eine Leiterplatte mit zwei übereinander im Inneren der Leiterplatte liegenden Leiterbahnen und einem darauf angeordneten Bauteil; und
Fig. 3 zeigt schematisch eine Leiterplatte mit einer innen liegenden Leiterbahn und einem damit mit einer sehr belastbaren mechanischen Verbindung verbundenen Bauteil.

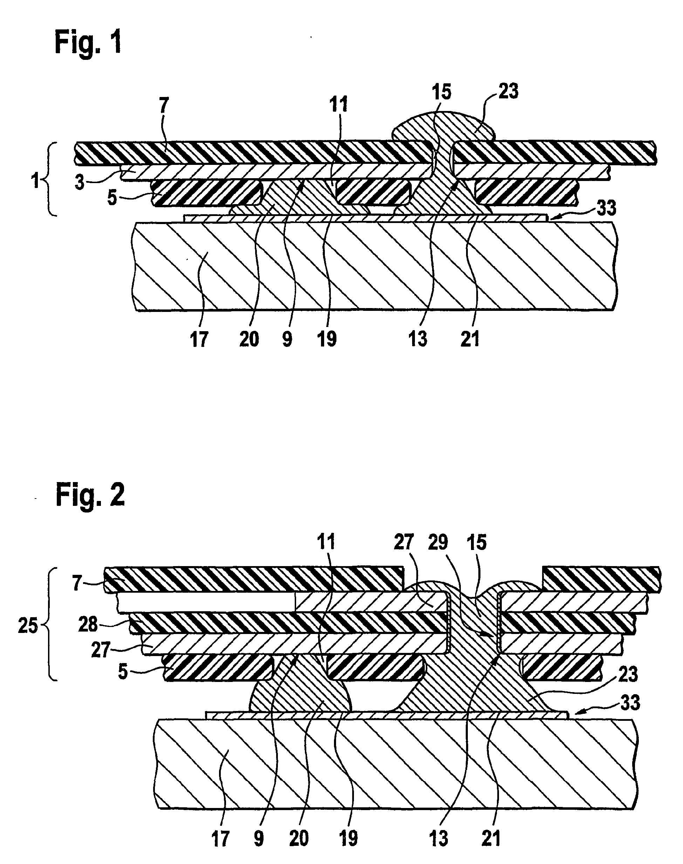

Fig. 1 zeigt schematisch eine Leiterplatte 1 mit einer innen liegenden Leiterbahn 3. Auf einer ersten Oberfläche der Leiterplatte 1 ist eine erste Isolationsschicht 5 angeordnet und auf einer zweiten zweiten Oberfläche der Leiterplatte 1 ist eine zweite Isolationsschicht 7 angeordnet.

Bei der Leiterplatte 1 handelt es sich z.B. um eine flexible Leiterplatte mit einer Leiterbahn 3 aus Kupfer. Die Isolationsschichten 5, 7 können z.B. Polimidfolien sein. Alternativ kann die Leiterplatte 1 eine handelsübliche starre Leiterplatte, z.B. aus einem Isolierstoff auf Epoxidharzbasis, sein.

Die Leiterplatte 1 weist eine erste Kontaktstelle 9 auf, an der die Leiterbahn 3 durch eine Ausnehmung 11 in der ersten Isolationsschicht 5 zugänglich ist. Weiter weist die Leiterplatte 1 eine zweite Kontaktstelle 13 auf, an der die Leiterbahn 3 durch eine die Leiterplatte 1 vollständig durchdringende Bohrung 15 zugänglich ist.

Auf der ersten Oberfläche der Leiterplatte 1 ist ein elektronisches Bauteil 17 angeordnet. Das Bauteil 17 weist eine erste Kontaktfläche 19 auf, die mit der ersten Kontaktstelle 9 durch eine Lötung oder eine Klebung mit einem elektrisch leitfähigen Kleber verbunden ist.
Hierzu ist ein Verbindungsmaterial 20, hier ein Lotpunkt oder ein Kleberpunkt, auf die Kontaktfläche 19 aufgebracht. Durch ein Aufbringen des Bauteils 17 wird das Verbindungsmaterial 20 in die Ausnehmung 11 eingebracht und stellt dort eine elektrisch leitfähige Verbindung von der Kontaktfläche 19 zu dem durch die Ausnehmung 11 freigelegten Abschnitt der Leiterbahn 3 her. Durch die Lötung oder Klebung besteht eine mechanisch feste Verbindung zwischen der Leiterplatte 1 und dem Bauteil.
Das Verbindungsmaterial 20 ist in der Ausnehmung 11 eingeschlossen und kann beim Herstellen der Verbindung nicht entweichen. Diese Art der Verbindung bietet somit eine sehr hohe elektrische Kontaktsicherheit.

Zusätzlich weist das Bauteil 17 eine zweite Kontakfläche 21 auf, die mit der zweiten Kontaktstelle 13 durch eine Lötung oder eine Klebung verbunden ist.
Auch dort ist ein Verbindungsmaterial 23, hier ein Lotpunkt oder ein Kleberpunkt, auf die Kontaktfläche 21 aufgebracht. Durch ein Aufbringen des Bauteils 17 wird das Verbindungsmaterial 23 in die Bohrung 15 eingebracht und stellt dort eine elektrisch leitfähige Verbindung von der Kontaktfläche 21 zu dem durch die Bohrung 15 freigelegten Abschnitt der Leiterbahn 3 her. Überschüssiges Verbindungsmaterial 23 tritt durch die Bohrung 15 aus. Durch die Lötung oder Klebung besteht eine mechanisch feste Verbindung zwischen der Leiterplatte 1 und dem Bauteil. Aufgrund der großen mit dem Verbindungsmaterial 23 benetzten Oberfläche ist diese Verbindung sehr belastbar.

Die Wahl der Verbindungsmaterialien hängt dabei von den sonstigen Gegebenheiten ab. Bestehen die Kontaktflächen 19, 21 aus einem Material, wie z.B. Nickel-Kupfer, auf dem ein Lot nur schlecht hält, wird immer ein Leitkleber verwendet werden; bestehen die Kontaktflächen 19, 21 dagegen aus einem Material das beide Verbindungsmaterialien zuläßt, z.B. aus Silber, so wird man die Verbindungsmaterialien in Abhängigkeit von deren Temperaturbeständigkeit und deren mechanischer Festigkeit wählen. Untersuchungen haben gezeigt, daß in Verbindung mit der Ausnehmung 11 bevorzugt ein elektrisch leitfähiger Kleber, zur Erzielung einer hohen Kontaktsicherheit eingesetzt wird, und in Verbindung mit der Bohrung 15 bevorzugt ein Lot zur Erzielung einer hohen mechanischen Festigkeit eingesetzt wird.

Insb. Lötverbindungen sind empfindlich gegenüber Schälbelastungen. Bei einer Verbindungstechnik, wie sie an der zweiten Kontaktstelle 13 vorliegt, wirkt eine an der Leiterplatte 1 angreifende Schälbelastung jedoch auf das in der Bohrung 15 befindliche Lot auch in Form einer Zugbelastung ein. Gegenüber Zugbelastungen ist eine Lotverbindung jedoch sehr viel beständiger. Entsprechend wird durch die hier vorgesehene Verbindungstechnik eine Verbindung mit einer sehr hohen mechnischen Festigkeit gewährleistet.

Zusätzlich bietet diese Verbindungsform den Vorteil, daß der Herstellprozeß kontrollierbar ist. Dadurch, daß Verbindungsmaterial 23 durch die Bohrung 15 austritt oder zumindest durch die Bohrung 15 hindurch von der zweiten Oberfläche her sichtbar ist, kann kontrolliert werden, ob Verbindungsmaterial in ausreichender Menge aufgebracht wurde.

Fig. 2 zeigt ein weiteres Ausführungsbeispiel einer erfindungsgemäßen Leiterplatte 25. Aufgrund der großen Übereinstimmung zu dem vorangehenden Ausführungsbeispiel werden nachfolgend lediglich die bestehenden Unterschiede näher erläutert.

Bei der Leiterplatte 25 handelt es sich um eine beidseitig mit Bauteilen bestückbare Leiterplatte, die zwei von einander beabstandete zueinander parallele innen liegende Leiterbahnen 27 aufweist. Neben den beiden äußeren Isolationsschichten 5, 7 weist die Leiterplatte 25 zusätzlich eine innen zwischen den beiden Leiterbahnen 27 verlaufende mittlere Isolationsschicht 28 auf.

Analog zu dem vorangehenden Ausführungsbeispiel weist die Leiterplatte 25 eine ersten Kontaktstelle 9 auf an der die der ersten Isolationsschicht 5 zugewandte Leiterbahn 27 durch eine Ausnehmung 11 in der ersten Isolationsschicht 5 zugänglich ist.

Ebenfalls analog zum vorangehenden Ausführungsbeispiel weist die Leiterplatte 25 eine zweite Kontaktstelle 23 auf, an der die Leiterbahnen 27 durch die die Leiterplatte 25 vollständig durchdringende Bohrung 15 zugänglich sind. Die Bohrung 15 weist im Bereich der beiden Leiterplatten 27 eine Metallisierung 29 auf, durch die die Leiterplatten 27 elektrisch leitend verbunden sind.

Das elektronischen Bauteil 17 ist auf der ersten Oberfläche angeordnet und dessen erste Kontaktfläche 19 ist mit der ersten Kontaktstelle 9 durch eine Lötung oder eine Klebung mit einem elektrisch leitfähigen Kleber verbunden. Die zweite Kontakfläche 21 ist mit der zweiten Kontaktstelle 13 durch eine Lötung oder eine Klebung verbunden. Die Metallisierung bietet den Vorteil, daß durch sie die durch die Bohrung 15 bestehende große Oberfläche als Kontaktfläche optimal genutzt wird.

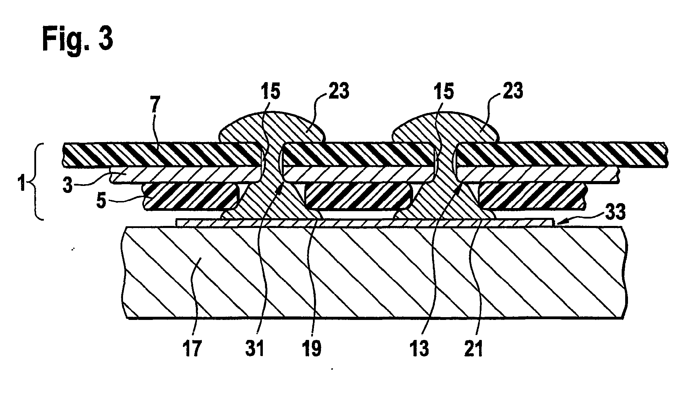

Fig. 3 zeigt ein weiteres Ausführungsbeispiel. Aufgrund der großen Übereinstimmung zu dem in Fig. 1 dargestellten Ausführungsbeispiel werden nachfolgend lediglich die bestehenden Unterschiede nähere erläutert.

Bei dem in Fig. 3 dargestellten Ausführungsbeispiel
weist die Leiterplatte 1 eine erste Kontaktstelle 31 auf, an der die Leiterbahn 3 durch eine die Leiterplatte 1 vollständig durchdringende Bohrung 15 zugänglich ist, und sie weist die zweite Kontaktstelle 13 auf, an der die Leiterbahn 3 ebenfalls durch die die Leiterplatte 1 vollständig durchdringende Bohrung 15 zugänglich ist. Die Verbindung der Kontaktflächen 19, 21 des Bauteil 17 mit der ersten und der zweiten Kontaktstelle 31, 13 erfolgt auch hier wieder durch eine Lötung oder eine Klebung. Die Ausbildung von zwei Kontaktstellen 31, 13 mit Bohrungen 15 bietet eine besonders hohe mechanische Belastbarkeit, und ist immer dann bevorzugt einzusetzen, wenn extreme mechanische Belastungen zu erwarten sind.

Erfindungsgemäß ist also, wie anhand der Ausführungsbeispiele beschrieben, die Leiterplatte 1 jeweils über eine erste mit einer ersten Kontaktfläche 19 verbundenen Kontaktstelle 9, 31 und eine zweite mit einer zweiten Kontaktfläche 21 verbundenen zweiten Kontaktstelle 13 elektrisch und mechanisch mit dem Bauteil 17 verbunden und mindestens eine Kontaktstelle 13 besteht in einer die Leiterplatte 1 bzw. 25 vollständig durchdringenden Bohrung 15, durch die die Leiterbahn 3 zugänglich ist bzw. die Leiterbahnen 27 zugänglich sind.

Bei den in Figuren dargestellten Ausführungsbeispielen ist das Bauteil 17 ein piezoelektrisches Element, das mindestens eine flächig aufgebrachte Elektrode 33 aufweist. Die Kontaktflächen 19, 21 sind Teilflächen der Elektroden 33. Entsprechend bilden die erste und die zweite Kontaktfläche 19, 21 elektrisch eine Einheit. Es besteht somit eine Redundanz die eine erhöhte Sicherheit bietet.

## Patentansprüche

1. Leiterplatte (1) mit
- mindestens einer innen liegenden Leiterbahn (3),
- einer ersten auf einer ersten Oberfläche der Leiterplatte (1) angeordneten Isolationsschicht (5),
- einer zweiten auf einer zweiten Oberfläche der Leiterplatte (1) angeordneten Isolationsschicht (7),
- einer ersten Kontaktstelle (9, 31) an der die Leiterbahn (3) zugänglich ist,
- einer zweiten Kontaktstelle (13), an der die Leiterbahn (3) durch eine die Leiterplatte (1) vollständig durchdringende Bohrung (15) zugänglich ist, und
- einem auf der ersten Oberfläche angeordneten elektronischen Bauteil (17), - das eine erste Kontaktfläche (19) aufweist, die mit der ersten Kontaktstelle (9, 31) durch eine Lötung oder eine Klebung mit einem elektrisch leitfähigen Kleber verbunden ist, und
-- das eine zweite Kontaktfläche (21) aufweist, die mit der zweiten Kontaktstelle (13) durch eine Lötung oder eine Klebung verbunden ist.

2. Leiterplatte nach Anspruch 1 mit
- zwei von einander beabstandeten zueinander parallelen innen liegenden Leiterbahnen (27),
-- wovon jene, die der ersten Oberfläche zugewandt ist, an der ersten Kontaktstelle (9) zugänglich ist, und
- wobei beide Leiterbahnen (27) durch die Bohrung (15) zugänglich sind.

3. Leiterplatte (25) nach Anspruch 2, bei der
die Bohrung (15) im Bereich der beiden Leiterbahnen (27) eine Metallisierung (29) aufweist.

4. Leiterplatte (1, 25) nach Anspruch 1 oder 2, bei der
die Leiterbahn (3, 27) an der ersten Kontaktstelle durch eine Ausnehmung (11) in der ersten Isolationsschicht (5) zugänglich ist.

5. Leiterplatte (1) nach Anspruch 1 oder 2, bei der die
Leiterbahn (3) an der ersten Kontaktstelle (31) durch eine die Leiterplatte (1) vollständig durchdringende Bohrung (15) zugänglich ist.

6. Leiterplatte (1, 25) nach einem der vorangehenden
Ansprüche, bei der das Bauteil (179 ein piezoelektrisches Element ist, das mindestens eine flächig aufgebrachte Elektrode (33) aufweist, und die Kontaktflächen (19, 21) Teilflächen der Elektrode (33) sind.

7. Leiterplatte (1, 25) nach einem der vorangehenden
Ansprüche, bei der die erste und die zweite Kontaktfläche (19, 21) elektrisch eine Einheit bilden.

## Claims

1. Circuit board (1), having
- at least one internally situated conductor path (3),
- a first insulating layer (5) arranged on a first surface of the circuit board (1),
- a second insulating layer (7) arranged on a second surface of the circuit board (1),
- a first contact location (9, 31), at which the conductor path (3) is accessible,
- a second contact location (13), at which the conductor path (3.) is accessible through a bore (15) passing completely through the circuit board (1), and
- an electronic component (17) arranged on the first surface,
-- which exhibits a first contact area (19), which is connected to the first contact location (9, 31) by soldering or adhesive bonding using an electrically conductive adhesive, and
-- which exhibits a second contact area (21), which is connected to the second contact location (13) by soldering or adhesive bonding.

2. Circuit board according to Claim 1, having
- two spaced apart, mutually parallel, internally situated conductor paths (27),
-- of which the one facing the first surface is accessible at the first contact location (9), and
- both conductor paths (27) being accessible through the bore (15).

3. Circuit board (25) according to Claim 2, wherein the bore (15) has plating-through (29) in the region of the two conductor paths (27).

4. Circuit board (1, 25) according to Claim 1 or 2, wherein the conductor path (3, 27) is accessible at the first contact location through an opening (11) in the first insulating layer (5).

5. Circuit board (1) according to Claim 1 or 2, wherein the conductor path (3) is accessible at the first contact location (31) through a bore (15) passing completely through the circuit board (1).

6. Circuit board (1, 25) according to one of the preceding claims, wherein the component (17) is a piezoelectric element, which has at least one flatly applied electrode (33), and the contact areas (19, 21) are sub-areas of the electrode (33).

7. Circuit board (1, 25) according to one of the preceding claims, wherein the first and second contact surfaces (19, 21) electrically form a unit.

## Revendications

1. Circuit imprimé (1) avec
- au moins une piste (3) située sur la face intérieure,
- une première couche isolante (5) disposée sur une première surface du circuit imprimé (1),
- une deuxième couche isolante (7) disposée sur une deuxième surface du circuit imprimé (1),
- un premier point de contact (9, 31), au niveau duquel la piste (3) est accessible,
- un deuxième point de contact (13), au niveau duquel la piste (3) est accessible au moyen d'un trou de perçage (15) traversant entièrement le circuit imprimé (1), et
- un composant électronique (17) disposé sur la première surface,
-- qui présente une première surface de contact (19), laquelle est reliée au premier point de contact (9, 31) par soudage ou par collage à l'aide d'une colle électroconductrice, et
-- qui présente une deuxième surface de contact (21), laquelle est reliée au deuxième point de contact (13) au moyen d'un soudage ou d'un collage.

2. Circuit imprimé selon la revendication 1, avec
- deux pistes (27) parallèles, espacées l'une par rapport à l'autre, se trouvant sur la face intérieure,
-- parmi lesquelles celle attribuée à la première surface est accessible au niveau du premier point de contact (9), et
- les deux pistes (27) étant accessibles à travers le trou de perçage (15).

3. Circuit imprimé (25) selon la revendication 2, pour lequel le trou de perçage (15) présente une métallisation (29) dans la zone des deux pistes (27).

4. Circuit imprimé (1, 25) selon la revendication 1 ou 2, pour lequel la piste (3, 27) est accessible au niveau du premier point de contact à travers une entaille (11) réalisée dans la première couche isolante (5).

5. Circuit imprimé (1) selon la revendication 1 ou 2, pour lequel la piste (3) est accessible au niveau du premier point de contact (31) à travers un trou de perçage (15) traversant entièrement le circuit imprimé (1).

6. Circuit imprimé (1, 25) selon l'une des revendications précédentes, pour lequel le composant (17) est un élément piézoélectrique, qui comporte au minimum une électrode (33) présentant une grande surface plane, et pour lequel les surfaces de contact (19, 21) sont des surfaces partielles de l'électrode (33).

7. Circuit imprimé (1, 25) selon l'une des revendications précédentes, pour lequel la première et la deuxième surface de contact (19, 21) forment une unité d'un point de vue électrique.
